# EUROPEAN PATENT APPLICATION

(11) **EP 4 489 062 A1**
(43) Date of publication of application: **08.01.2025**
(21) Application number: 23763615.4
(22) Date of filing: 18.01.2023
(51) Int. Cl.: H01L 21/677, G02F 1/13, B61B 13/02, B61F 9/00

(54) **GUIDE MODULE AND DRIVING DEVICE PROVIDED WITH SAME**

(30) Priority: 02.03.2022 KR 20220026809
(71) Applicant: IGB CO., LTD., Asan-si Chungcheongnam-do 31550 (KR)
(72) Inventor: LIM, Sun Ho, Asan-si Chungcheongnam-do 31533 (KR)
(74) Representative: Patentanwälte Hemmer Lindfeld Frese Partnerschaft mbB
(86) International application number: PCT/KR2023/000848
(87) International publication number: WO 2023/167416

(57) **Abstract**

Disclosed are a guide module and a driving device provided with the same. A driving device according to an embodiment of the present inventive concept includes: a rack formed in at least any one combination of a straight rack portion of a straight type and a curved rack portion of a curved type; a pinion interacting with the rack and moving along a straight or curved trajectory of the rack; a moving unit connected to the pinion and moving along the trajectory of the rack with the pinion; and a guide module connected to the moving unit and guiding a movement of the moving unit that moves along the trajectory of the rack, wherein the guide module includes: a pair of module rails, each including a rail block and arranged on one side of the rack forming a same trajectory as the rack; and a pair of slipping prevention guide assemblies connected to the moving unit forming one body with the pinion, one of which being movably coupled to each of the pair of module rails, and moving along the trajectory of each of the pair of module rails and guiding the movement of the moving unit to prevent occurrence of slipping.

## Description

### TECHNICAL FIELD

The present inventive concept relates to a guide module and a driving device provided with the same, and more particularly, to a guide module which may smoothly guide a movement of a moving unit while preventing slipping occurring when the moving unit mounted on a pinion moves along a straight or curved trajectory of a rack, thereby deriving a stable operation of the moving unit, and to a driving device provided with the same.

### BACKGROUND ART

Driving devices may be applied to various industrial equipment including semiconductor equipment, flat display equipment such as LCD, PDP, and OLED, and the like, to implement a straight or curved motion.

In this state, a moving unit that is a movement object constituting a driving device may perform a straight or curved motion according to an interaction between a rack and a pinion. For example, when the rack is of a straight type, the moving unit may be capable of a straight motion with an interaction with the pinion, and when the rack is of a curved type, the moving unit may be capable of a curved motion with an interaction with the pinion.

Accordingly, the straight or curved motion of the moving unit may be implemented by appropriately combining the rack and pinion, and the moving unit, based on the structures and functions described above. Based on this, various industrial equipment may be used suitable for corresponding processes, for example, a transportation process of transporting objects placed on the moving unit.

Meanwhile, in the combination of a rack and a pinion, when the pinion alone performs a straight motion or curved motion along the trajectory of the rack, as the weight of the pinion is not much, there are no significant obstacles to the driving of the pinion.

However, as described above, when the moving unit that is a heavy body is mounted on the pinion and further an object is placed thereon and then the moving unit is moved or operated by the operations of the rack and the pinion, a device for guiding the movement of the moving unit is required. When the movement of the moving unit is not guided, it may be difficult to derive a stable operation of the moving unit, and in particular, when the moving unit that is a heavy body or an object placed thereon is to be moved, lots of load is applied to the rack or the pinion so that durability of a device may deteriorate.

However, in the related art for implementing a driving device by an interaction between a rack and a pinion, a device for guiding the movement of the moving unit mounted on the pinion, for example, a guide module, has not been adopted, or even when the guide module is disclosed, due to its structural limitations, slipping may occur in a so-called straight-curved trajectory movement of moving from a curved trajectory to a straight trajectory, or from a straight trajectory to a curved trajectory. Thus, there is a need to develop technology to address the issue.

### DETAILED DESCRIPTION OF THE INVENTIVE CONCEPT

### TECHNICAL PROBLEM

The present inventive concept provides a guide module which may smoothly guide a movement of a moving unit while preventing slipping occurring when the moving unit mounted on a pinion moves along a straight or curved trajectory of a rack, thereby deriving a stable operation of the moving unit, and a driving device provided with the guide module.

### ADVANTAGEOUS EFFECTS

According to the present inventive concept, the movement of a moving unit may be smoothly guided while occurrence of slipping is prevented when the moving unit mounted on a pinion moves along a straight or curved trajectory of a rack, thereby deriving a stable operation of the moving unit.

### DESCRIPTION OF THE DRAWINGS

- FIG. 1: is a perspective view of a driving device according to an embodiment of the present inventive concept.
- FIG. 2: is an enlarged view of a region A of FIG. 1.
- FIG. 3: is a view showing that a module rail is removed in FIG. 2.
- FIG. 4: is a view showing that a moving unit is removed in In FIG. 2.
- FIG. 5: is a perspective bottom view of FIG. 4.
- FIG. 6: is a view showing that a detachable block cover is removed in FIG. 5.
- FIG. 7: is an arrangement view of a pinion and a rack.
- FIG. 8: is an enlarged view of a region B of FIG. 4 in which a slipping prevention guide assembly is placed on a rail block.
- FIG. 9: is a view showing FIG. 8 at a different angle.
- FIG. 10: is a view showing that a rail block is removed in FIG. 8.
- FIG. 11: is an exploded perspective view of FIG. 10.
- FIG. 12: is a perspective view of a unit guide unit.
- FIG. 13: is an exploded perspective view of FIG. 12.
- FIG. 14: is a perspective view of a roller support casing.
- FIG. 15: is a rear perspective view of FIG. 13.
- FIG. 16: is a perspective view of a driving device according to another embodiment of the present inventive concept.
- FIG. 17: is an enlarged view of a region C of FIG. 16.

### BEST MODE

According to an aspect of the present inventive concept, a driving device includes: a rack formed in at least any one combination of a straight rack portion of a straight type and a curved rack portion of a curved type; a pinion interacting with the rack and moving along a straight or curved trajectory of the rack; a moving unit connected to the pinion and moving along the trajectory of the rack with the pinion; and a guide module connected to the moving unit and guiding a movement of the moving unit that moves along the trajectory of the rack, wherein the guide module includes: a pair of module rails, each including a rail block and arranged on one side of the rack forming a same trajectory as the rack; and a pair of slipping prevention guide assemblies connected to the moving unit forming one body with the pinion, one of which being movably coupled to each of the pair of module rails, and moving along the trajectory of each of the pair of module rails and guiding the movement of the moving unit to prevent occurrence of slipping.

The pair of slipping prevention guide assemblies may have an identical structure, and each of the pair of slipping prevention guide assemblies may include a plurality of unit guide units, each of the plurality of unit guide units including an upper roller, a lower roller, and a side roller which are respectively guided in rolling contact with all of an upper surface, a lower surface, and a side surface of the rail block.

Each of the pair of slipping prevention guide assemblies may further include a unit connection portion that connects the plurality of unit guide units into one body to allow the plurality of unit guide units to perform a relative movement or a relative rotation on the rail block.

The unit connection portion may include a main unit body connected to a pair of unit guide units arranged in the middle among the plurality of unit guide units, and a plurality of individual unit connectors, each individually connecting each pair of unit guide units arranged on one side and another side among the plurality of unit guide units.

The unit connection portion may further include a pair of center bearings respectively coupled to both sides of the main unit body, a plurality of side bearings respectively provided at center portions of the individual unit connectors, and a pair of link arms, both end portions of each of which are respectively coupled to each of the plurality of center bearings and each of the plurality of side bearings to be capable of free rotation.

Each of the plurality of unit guide units may include a roller support casing rotatably supporting the upper roller, the lower roller, and the side roller, an upper flat guide having a flat shape, connected to the upper roller to prevent slipping when the upper roller rolls on an upper surface of the rail block, and connected to an upper coupling hole of the roller support casing with adjustable clearance, a lower flat guide having a flat shape, connected to the lower roller to prevent slipping when the lower roller rolls on a lower surface of the rail block, and connected to a lower coupling hole of the roller support casing with adjustable clearance, and a side flat guide having a flat shape, connected to the side roller to prevent slipping when the side roller rolls on a side surface of the rail block, and connected to a side coupling hole of the roller support casing with adjustable clearance.

Each of the plurality of unit guide units may further include an upper guide fastening plate fastening the upper flat guide at an opposite side of the upper flat guide with the upper coupling hole therebetween, a lower guide fastening plate fastening the lower flat guide at an opposite side of the lower flat guide with the lower coupling hole therebetween, a side guide fastening plate fastening the side flat guide at an opposite side of the side flat guide with the side coupling hole therebetween, and a plurality of fastening bolts fastening corresponding ones of the upper guide fastening plate and the upper flat guide, the lower guide fastening plate and the lower flat guide, and the side guide fastening plate and the side flat guide.

Each of the plurality of unit guide units may further include an upper guide assembly portion assembling the upper roller and the upper flat guide, a lower guide assembly portion assembling the lower roller and the lower flat guide, and a side guide assembly portion assembling the side roller and the side flat guide.

Each of the plurality of unit guide units may further include a plurality of preload bolt fastened to the roller support casing and applying a preload for clearance adjustment of the upper roller, the lower roller, and the side roller.

Each of the pair of module rails may further include a detachable block cover covering and protecting the rail block and detachably coupled to the rail cover.

The pair of module rails may be arranged on both sides of the rack with the rack therebetween.

According to another aspect of the present inventive concept, a guide module is arranged in at least any one side of a rack that interacts with a pinion, connected to a moving unit that moves along a trajectory of the rack with the pinion, and guiding a movement of the moving unit, the guide module including a pair of module rails, each including a rail block and arranged on one side of the rack forming the same trajectory as the rack, and a pair of slipping prevention guide assemblies connected to the moving unit forming one body with the pinion, one of which being movably coupled to each of the pair of module rails, and moving along the trajectory of the module rail and guiding the movement of the moving unit to prevent occurrence of slipping.

The pair of slipping prevention guide assemblies may have an identical structure, and each of the pair of slipping prevention guide assemblies may include a plurality of unit guide units, each of the plurality of unit guide units including an upper roller, a lower roller, and a side roller which are respectively guided in rolling contact with all of an upper surface, a lower surface, and a side surface of the rail block, and a unit connection portion that connects the plurality of unit guide units into one body to allow the plurality of unit guide units to perform a relative movement or a relative rotation on the rail block.

The unit connection portion may include a main unit body connected to a pair of unit guide units arranged in a middle among the plurality of unit guide units, a plurality of individual unit connectors, each individually connecting each pairof unit guide units arranged in one side and another side among the plurality of unit guide units, a pair of center bearings respectively coupled to both sides of the main unit body, a plurality of side bearings respectively provided at center portions of the individual unit connectors, and a pair of link arms, both end portions of each of which are respectively coupled to each of the plurality of center bearings and each of the plurality of side bearings to be capable of free rotation.

Each of the plurality of unit guide units may include a roller support casing rotatably supporting the upper roller, the lower roller, and the side roller, an upper flat guide having a flat shape, connected to the upper roller to prevent slipping when the upper roller rolls on an upper surface of the rail block, and connected to an upper coupling hole of the roller support casing with adjustable clearance, a lower flat guide having a flat shape, connected to the lower roller to prevent slipping when the lower roller rolls on a lower surface of the rail block, and connected to a lower coupling hole of the roller support casing with adjustable clearance, and a side flat guide having a flat shape, connected to the side roller to prevent slipping when the side roller rolls on a side surface of the rail block, and connected to a side coupling hole of the roller support casing with adjustable clearance.

Each of the plurality of unit guide units may further include an upper guide fastening plate fastening the upper flat guide at an opposite side of the upper flat guide with the upper coupling hole therebetween, a lower guide fastening plate fastening the lower flat guide at an opposite side of the lower flat guide with the lower coupling hole therebetween, a side guide fastening plate fastening the side flat guide at an opposite side of the side flat guide with the side coupling hole therebetween, and a plurality of fastening bolts fastening corresponding ones of the upper guide fastening plate and the upper flat guide, the lower guide fastening plate and the lower flat guide, and the side guide fastening plate and the side flat guide.

Each of the plurality of unit guide units may further include an upper guide assembly portion assembling the upper roller and the upper flat guide, a lower guide assembly portion assembling the lower roller and the lower flat guide, and a side guide assembly portion assembling the side roller and the side flat guide.

Each of the plurality of unit guide units may further include a plurality of preload bolt fastened to the roller support casing and applying a preload for clearance adjustment of the upper roller, the lower roller, and the side roller.

Each of the pair of module rails may further include a detachable block cover covering and protecting the rail block and detachably coupled to the rail cover.

The pair of module rails may be arranged on both sides of the rack with the rack therebetween.

### MODE OF THE INVENTIVE CONCEPT

The attached drawings for illustrating preferred embodiments of the present inventive concept are referred to in order to gain a sufficient understanding of the present inventive concept, the merits thereof, and the objectives accomplished by the implementation of the present inventive concept.

Hereinafter, the present inventive concept will be described in detail by explaining preferred embodiments of the inventive concept with reference to the attached drawings. Like reference numerals in the drawings denote like elements.

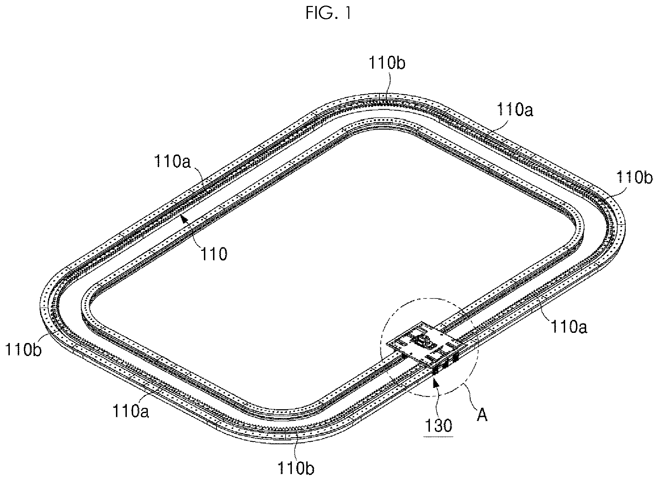

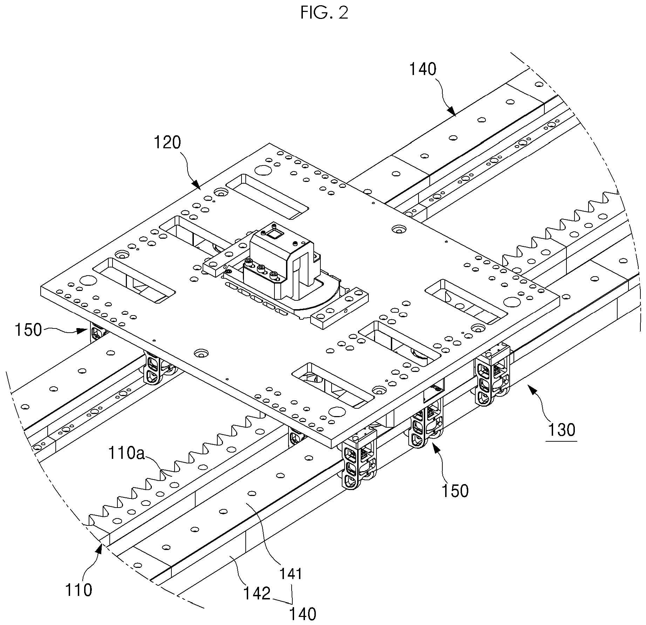

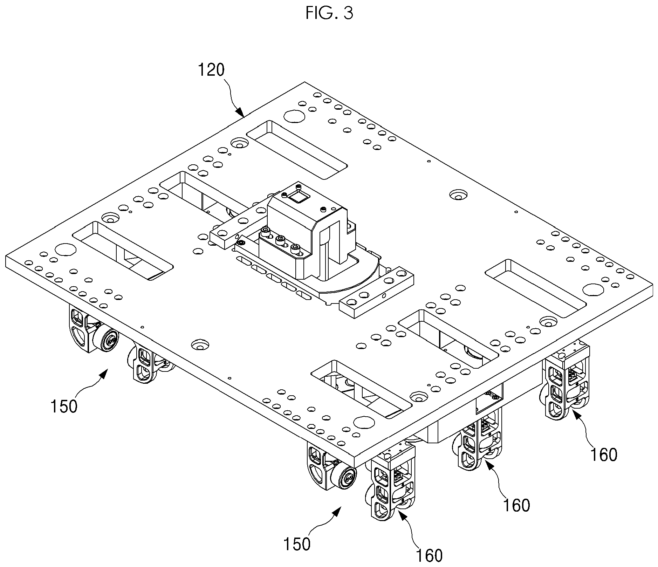

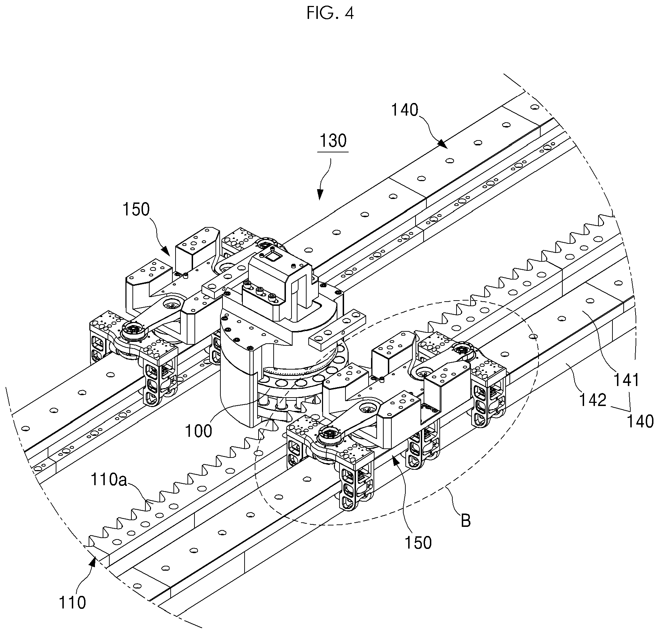

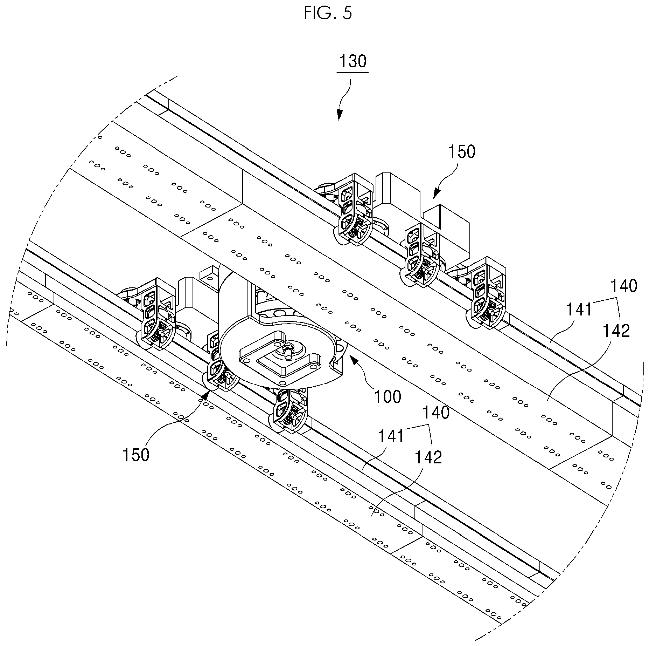

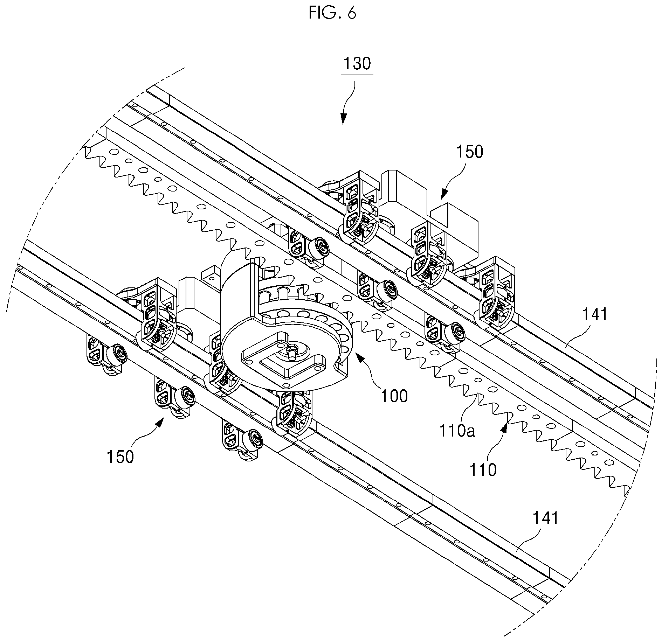

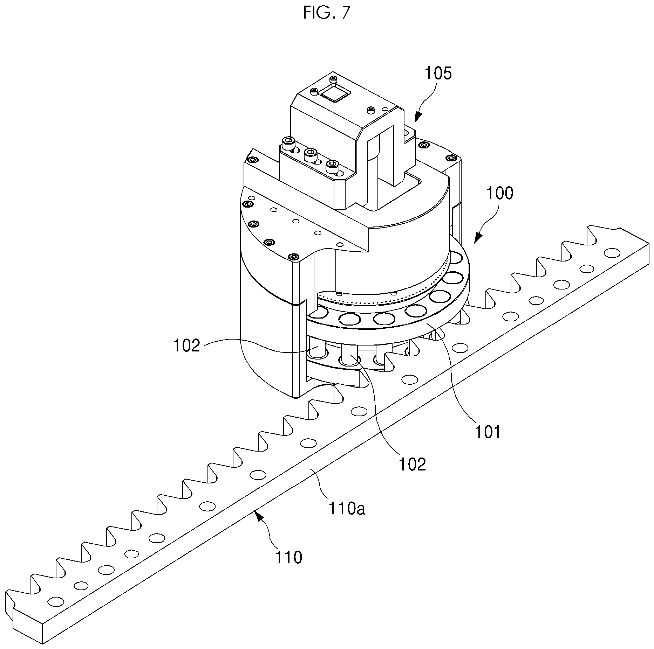

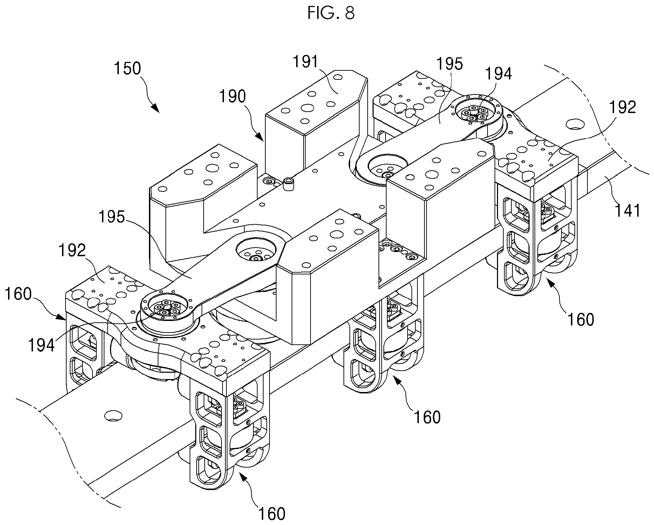

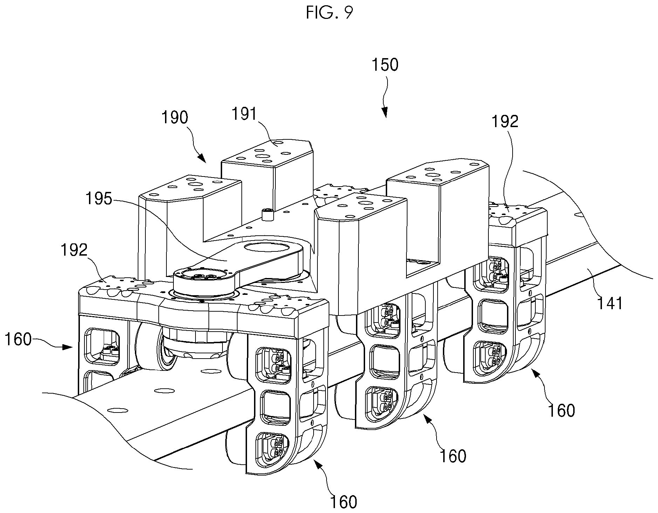

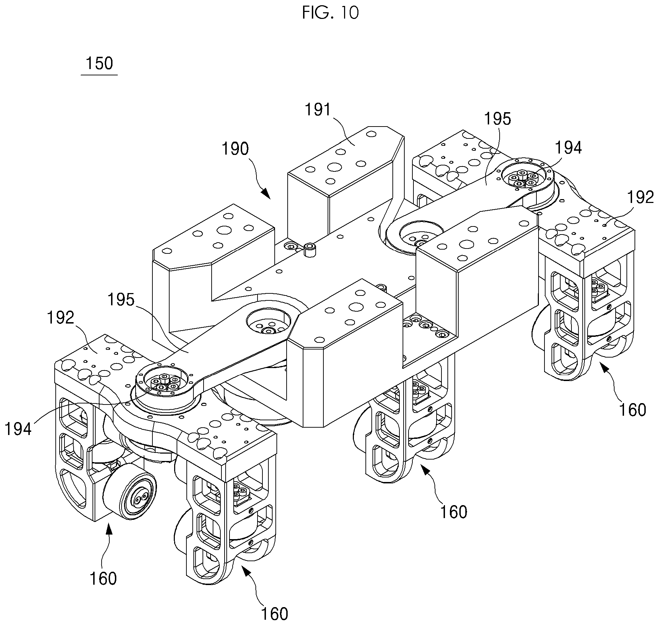

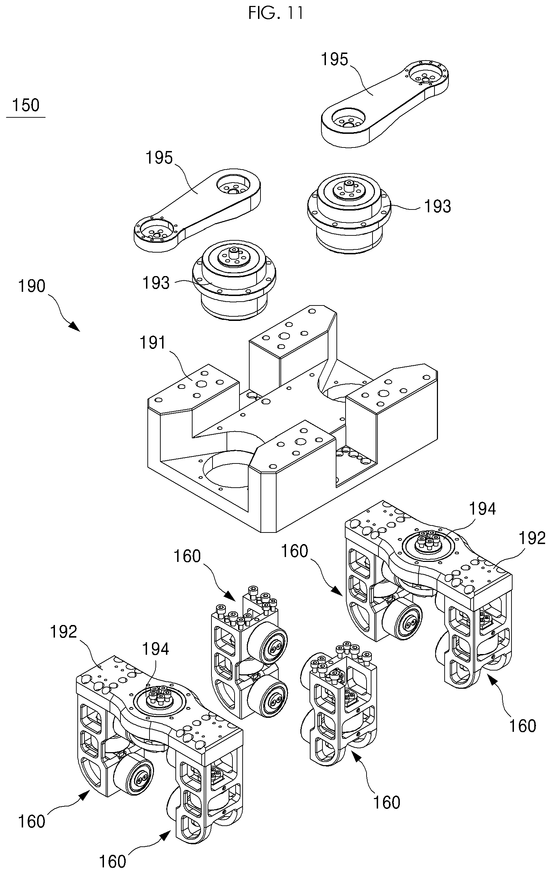

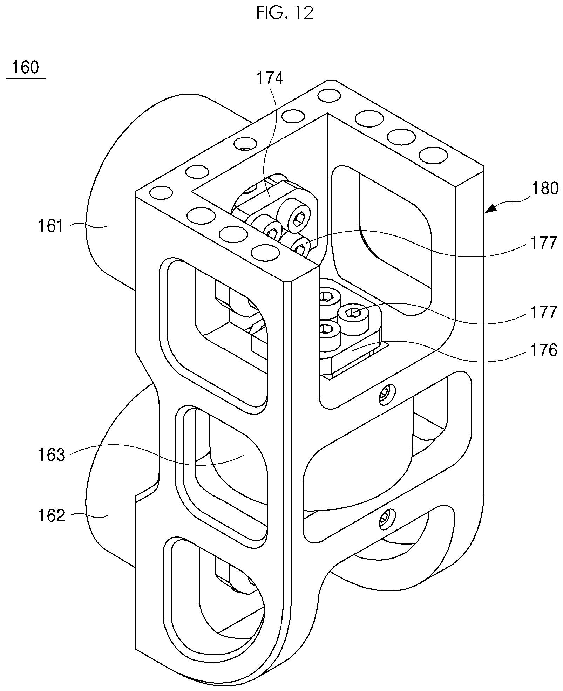

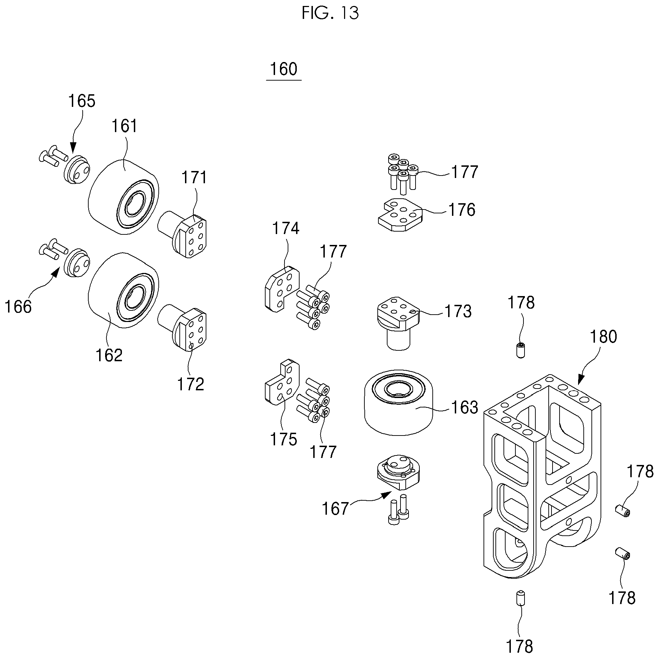

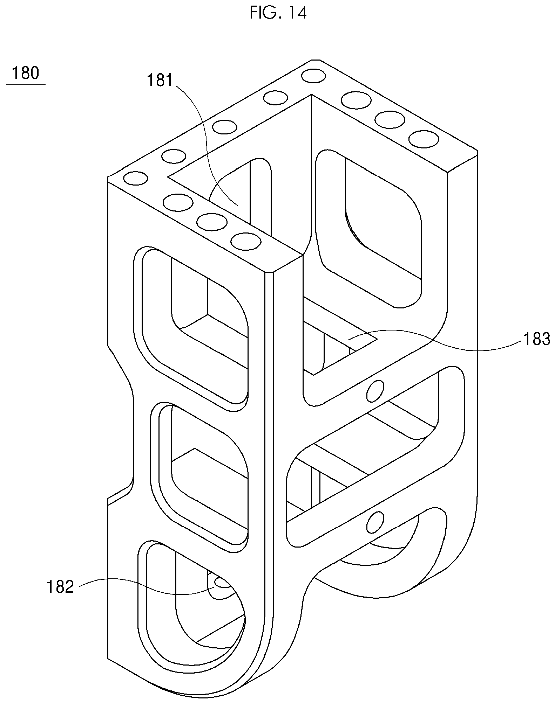

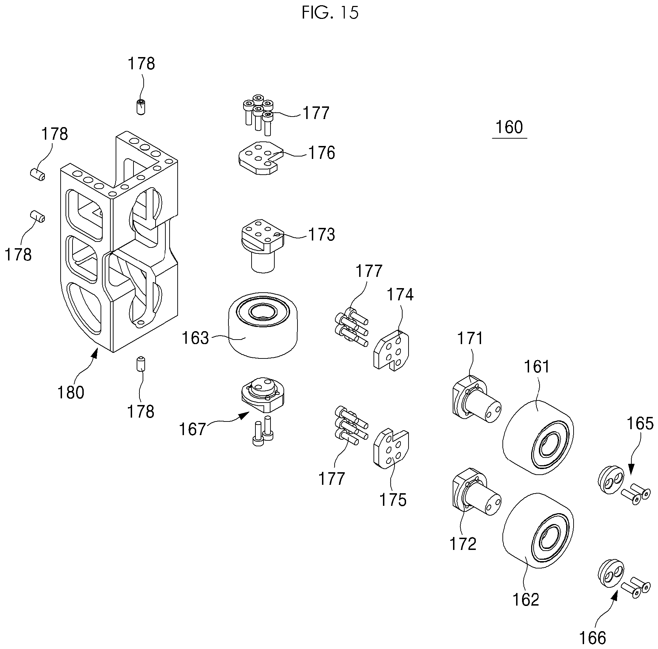

FIG. 1 is a perspective view of a driving device according to an embodiment of the present inventive concept. FIG. 2 is an enlarged view of a region A of FIG. 1. FIG. 3 is a view showing that a module rail is removed in FIG. 2. FIG. 4 is a view showing that a moving unit is removed in In FIG. 2. FIG. 5 is a perspective bottom view of FIG. 4. FIG. 6 is a view showing that a detachable block cover is removed in FIG. 5. FIG. 7 is an arrangement view of a pinion and a rack. FIG. 8 is an enlarged view of a region B of FIG. 4 in which a slipping prevention guide assembly is placed on a rail block. FIG. 9 is a view showing FIG. 8 at a different angle. FIG. 10 is a view showing that a rail block is removed in FIG. 8. FIG. 11 is an exploded perspective view of FIG. 10. FIG. 12 is a perspective view of a unit guide unit. FIG. 13 is an exploded perspective view of FIG. 12. FIG. 14 is a perspective view of a roller support casing. FIG. 15 is a rear perspective view of FIG. 13.

As illustrated in theses drawings, the driving device according to the present embodiment may be applied to various industrial equipment including semiconductor equipment, flat display equipment, for example, LCD, PDP, or OLED, and the like, to implement a straight or curved motion, and a guide module 130 of the driving device according to the present embodiment may guide a movement of a moving unit 120 when the moving unit 120 mounted on a pinion 100 moves along a trajectory of a rack 110. Also, the driving device according to the present embodiment may be applied to industrial fields other than the semiconductor equipment or the flat display equipment.

For example, when a transportation device widely applied to an equipment process of semiconductor equipment, flat display equipment, or the like is regarded as the moving unit 120, the moving unit 120 is mounted on the pinion 100 and then moves along the trajectory of the rack 110 by an interaction between the pinion 100 and the rack 110, thereby performing a corresponding process, that is, a transportation process of transporting goods.

In this state, unlike the prior art, in the present embodiment, when transporting goods, the moving unit 120 may be stably guided and moved. As in the present embodiment, when it is possible to guide the moving unit 120 mounted on the pinion 100 moving with the pinion 100 along the trajectory of the rack 110, the stable operation of the moving unit 120 may be derived, and furthermore, it may be prevented that durability deteriorates as an overload is applied to the device. Accordingly, application to actual equipment or facilities may be possible.

The driving device according to the present embodiment capable of providing such an effect may include the moving unit 120 mounted on the pinion 100 that interacts with the rack 110 and moving with the pinion 100 along the trajectory of the rack 110, and the guide module 130 arranged on both sides of the rack 110, connected to the moving unit 120, and guiding the movement of the moving unit 120 that moves with the pinion 100 along the trajectory of the rack 110.

The driving device according to the present embodiment transfer power through the interaction between the rack 110 and the pinion 100. In other words, when a pinion driving portion (105, see FIG. 7) connected to the pinion 100 operates to rotate the pinion 100, the pinion 100 may move along the trajectory of the rack 110, and as the moving unit 120 is mounted on the pinion 100, the moving unit 120 is allowed to move with the pinion 100 along the trajectory of the rack 110.

As described above, the moving unit 120 may be a transportation body that may be applied to an equipment process such as semiconductor equipment, flat display equipment, or the like. Accordingly, the drawings of the present embodiment illustrate the moving unit 120 as a plate having a certain thickness so that goods may be placed on the moving unit 120. However, the moving unit 120 is not necessarily a transportation body and, for example, may be applied as an index and the like, and thus, the right scope of the present inventive concept is not limited to the shape on the drawings.

As illustrated in the drawings, when the moving unit 120 has a large area, the moving unit 120 may be probably shaken while moving, and thus, the moving unit 120 may be guided not to be shaken. In other words, when the size of the moving unit 120 is large as shown in FIG. 1, the guide module 130 may be arranged around the rack 110 to guide the movement of the moving unit 120. In this case, a more stable operation, without shaking, of the moving unit 120 when moving may be derived.

Meanwhile, as described above, the driving device according to the present embodiment adopts a method in which the moving unit 120 moves through the interaction between the pinion 100 and the rack 110. Accordingly, prior to the guide module 130, the pinion 100 and the rack 110 are first described.

The pinion 100, as illustrated in FIGS. 4 to 7, rotates in contact with the rack 110, that is, by being circumscribed by the rack 110, thereby performing a straight motion or a curved motion along the trajectory of the rack 110. Also, the pinion 100 may be inscribed by the rack 110.

The pinion 100 may include a pinion body 101 having a disc shape and a plurality of power transfer pins 102 coupled to the pinion body 101. The power transfer pins 102 have a circularly arrangement structure on the pinion body 101, and are rotated in tooth engagement with the rack 110.

A pinion driving portion 105 is connected to the pinion 100 for rotation of the power transfer pins 102. The pinion driving portion 105 may employ a motor and gear parts and serve to rotate the pinion 100. When the pinion 100 is rotated by the pinion driving portion 105, the pinion 100 may move along the trajectory of the rack 110.

The rack 110 forms a trajectory on which the pinion 100 moves. As illustrated in FIGS. 1 and 7, in the present embodiment, the rack 110 may have a closed loop structure of a combination of a straight rack portion 110a and a curved rack portion 1 10b. Also, only the straight rack portion 110a may be used, or only the curved rack portion 110b may be used depending on facilities. However, a combination of the straight rack portion 110a the curved rack portion 110b is frequently used in semiconductor equipment and the like.

The moving unit 120 has, as described above, a structure of being mounted on the pinion 100 and moving with the pinion 100 along the trajectory of the rack 110. In the present embodiment, the moving unit 120 having a flat plate type structure is employed.

In the present embodiment, the moving unit 120 may be connected to the pinion 100. In other words, the moving unit 120 is assembled to the pinion driving portion 105 connected to the pinion 100 using a plurality of bolts. Accordingly, the pinion 100, the pinion driving portion 105, and the moving unit 120 operates together as one body. In addition, a pair of slipping prevention guide assemblies 150 forming the guide module 130 are also assembled to the moving unit 120. As a result, in FIG. 1 and FIG. 2, elements other than the rack 110 and a module rail 140 are assembled into one body, and the elements move along the trajectory of the rack 110 and are guided along the module rail 140.

Meanwhile, the guide module 130 is connected to the moving unit 120 and serves to guide the movement of the moving unit 120 moving along the trajectory of the rack 110. It is possible to connect the moving unit 120 to the pinion 100 to allow the pinion 100 to move along the trajectory of the rack 110. However, as described above, in this case, while moving, the moving unit 120 may be severely shaken. Accordingly, the guide module 130 is adopted to allow the moving unit 120 to be stably moved and guided without shaking.

The guide module 130 may include a pair of module rails 140 and a pair of slipping prevention guide assemblies 150 connected to the moving unit 120 forming one body with the pinion 100, one of which being movably coupled to each of the pair of module rails 140, and moving along the trajectory of the module rail 140 and guiding the movement of the moving unit 120 to prevent occurrence of slipping.

The module rail 140 may include a rail block 141 and a detachable block cover 142 covering and protecting the rail block 141 and detachably coupled to the rail block 141. In a case of the present embodiment, the pair of module rails 140 are arranged on both sides of the rack 110.

The pair of slipping prevention guide assemblies 150 are parts connected to the moving unit 120 forming one body with the pinion 100, and one of which is movably coupled to each of the pair of module rails 140. In other words, one of the slipping prevention guide assemblies 150 is coupled to one of the module rails 140. Accordingly, the pair of slipping prevention guide assemblies 150 have an identical structure. The pair of slipping prevention guide assemblies 150 may both include a plurality of unit guide units 160 and a unit connection portion 190.

The unit guide units 160 is a device substantially having rollers 161 to 163 mounted thereon and moving on the rail block 141 of the module rail 140. Although it is an embodiment, the unit guide units 160 may employ six unit guide units. The six unit guide units 160 have identical configuration and structure.

At first look at the unit connection portion 190, the unit connection portion 190 is a device to connect the plurality of unit guide units 160 into one body, as illustrated in FIGS. 8 to 11, to allow the plurality of unit guide units 160 to perform a relative movement or a relative rotation on the rail block 141. In other words, the unit connection portion 190 is provided to enable the six unit guide units 160 to move or rotate relative to one another.

The unit connection portion 190 may include a main unit body 191 provided to connect to a pair of unit guide units 160 arranged in the middle of the plurality of unit guide units 160, and a plurality of individual unit connectors 192 each individually connecting each pair of unit guide units 160 arranged on one side and on the other sideamong the plurality of unit guide units 160.

In addition, the unit connection portion 190 may further include a pair of center bearings 193 respectively connected to both sides of the main unit body 191, a plurality of side bearings 194 each provided at a center portion of each of the individual unit connectors 192, and a pair of link arms 195, both end potions of each of which are respectively coupled to the center bearings 193 and the side bearings 194 to be capable of free rotation.

As such, the main unit body 191 is connected to the pair of unit guide units 160 arranged in the middle, and the individual unit connector 192 is connected to each pair of the unit guide units 160 on both sides thereof. The center bearings 193 and the side bearings 194 are applied to the main unit body 191 and the individual unit connector 192 to be connected by the link arms 195, and thus, a relative movement or relative rotation operation with respect to the unit guide units 160 may be derived. In particular, among the plurality of unit guide units 160, each pair of the unit guide units 160 arranged on one side and the other side may also serve as a steer.

The unit guide units 160 is a device substantially having the rollers 161 to 163 mounted thereon and moving on the rail block 141 of the module rail 140, and the six unit guide units 160 have an identical configuration.

The unit guide units 160 may each include, as illustrated in FIGS. 8 to 15, an upper roller 161, a lower roller 162, and a side roller 163 which are respectively guided in rolling contact with all of an upper surface, a lower surface, and a side surface of the rail block 141 forming the module rail 140. All of the upper roller 161, the lower roller 162, and the side roller 163 are non-powered free rotation rollers.

The unit guide units 160 may include a roller support casing 180 that rotatably supports the upper roller 161, the lower roller 162, and the side roller 163, and have a structure through the following configuration and structure in which the upper roller 161, the lower roller 162, and the side roller 163 are rotatably coupled to the roller support casing 180 for each position.

In order for the upper roller 161, the lower roller 162, and the side roller 163 to be rotatably coupled to the roller support casing 180 for each position, an upper flat guide 171, a lower flat guide 172, and a side flat guide 173 are provided on the unit guide units 160.

The upper flat guide 171, as a structure having a flat shape, is connected to the upper roller 161 to prevent slipping when the upper roller 161 rolls on an upper surface of the rail block 141, and is connected to an upper coupling hole 181 of the roller support casing 180 with adjustable clearance.

The lower flat guide 172, as a structure having a flat shape, is also connected to the lower roller 162 to prevent slipping when the lower roller 162 rolls on a lower surface of the rail block 141, and is connected to a lower coupling hole 182 of the roller support casing 180 with adjustable clearance.

The side flat guide 173, as a structure having a flat shape, is also connected to the side roller 163 to prevent slipping when the side roller 163 rolls on a side surface of the rail block 141, and is connected to a side coupling hole 183 of the roller support casing 180 with adjustable clearance.

To assemble the upper flat guide 171, the lower flat guide 172, and the side flat guide 173 to the upper roller 161, the lower roller 162, and the side roller 163, respectively, provided are an upper guide assembly portion 165, a lower guide assembly portion 166, and a side guide assembly portion 167.

The upper guide assembly portion 165 is a device to assemble the upper roller 161 and the upper flat guide 171 using screws, the lower guide assembly portion 166 is a device to assemble the lower roller 162 and the lower flat guide 172 using screws, and the side guide assembly portion 167 is also a device to assemble the side roller 163 and the side flat guide 173 using screws.

To assemble each of the upper flat guide 171, the lower flat guide 172, and the side flat guide 173 assembled to the upper roller 161, the lower roller 162, and the side roller 163 by the upper guide assembly portion 165, the lower guide assembly portion 166, and the side guide assembly portion 167 to the roller support casing 180, provided are an upper guide fastening plate 174, a lower guide fastening plate 175, a side guide fastening plate 176, and fastening bolts 177.

The upper guide fastening plate 174 is a device to fasten the upper flat guide 171 at the opposite side of the upper flat guide 171 with the upper coupling hole 181 of the roller support casing 180 therebetween.

The lower guide fastening plate 175 is a device to fasten the lower flat guide 172 at the opposite side of the lower flat guide 172 with the lower coupling hole 182 of the roller support casing 180 therebetween.

The side guide fastening plate 176 is a device to fasten the side flat guide 173 at the opposite side of the side flat guide 173 with the side coupling hole 183 of the roller support casing 180 therebetween.

The fastening bolts 177 serve to fasten corresponding ones of the upper guide fastening plate 174 and the upper flat guide 171, the lower guide fastening plate 175 and the lower flat guide 172, and the side guide fastening plate 176 and the side flat guide 173.

As such, a central portion separation phenomenon of the upper roller 161, the lower roller 162, and the side roller 163 may be removed by arranging the upper guide fastening plate 174, the lower guide fastening plate 175, and the side guide fastening plate 176 at the upper flat guide 171, the lower flat guide 172 and the side flat guide 173 assembled to the upper roller 161, the lower roller 162, and the side roller 163 by the upper guide assembly portion 165, the lower guide assembly portion 166, and the side guide assembly portion 167, respectively, and fastening each corresponding ones or by position using the fastening bolts 177. In other words, in using a typical roller shaft structure, the central portion separation phenomenon is highly likely to occur, whereas, as in the present embodiment, the upper guide fastening plate 174 and the upper flat guide 171, the lower guide fastening plate 175 and the lower flat guide 172, the side guide fastening plate 176 and the side flat guide 173 are applied to connecting the upper roller 161, the lower roller 162, and the side roller 163 to the roller support casing 180, thereby addressing the conventional problem. Accordingly, when the guide module 130 to which the unit guide units 160 is applied is employed, it is advantageous to minimize slipping during curve and straight-curve turning (moving).

Preload bolts 178 are further applied to the unit guide units 160 of the present embodiment. The preload bolts 178 are fastened to the roller support casing 180 and serve to apply a preload for clearance adjustment of the upper roller 161, the lower roller 162, and the side roller 163.

As described above, in a state in which the pinion 100 is coupled to the rack 110 and the guide module 130 is arranged around the rack 110, as the moving unit 120 is coupled to the plurality of guide modules 130 and the pinion 100, during rotation of the pinion 100, the moving unit 120 may move along the trajectory of the rack 110, and in this state, as the guide module 130 is adopted, the stable movement of the moving unit 120 may be derived.

In particular, due to the efficient structure of the unit guide units 160 described above, that is, the efficient assembly structure of the upper roller 161, the lower roller 162, and the side roller 163, slipping occurring during the curve and straight-curve turning of the moving unit 120 may be minimized.

According to the present embodiment operating in the structure described above, slipping occurring when the moving unit 120 mounted on the pinion 100 moves along the straight or curved trajectory of the rack 110 may be prevented and also the movement of the moving unit 120 may be smoothly guided. Accordingly, the stable operation of the moving unit 120 may be derived.

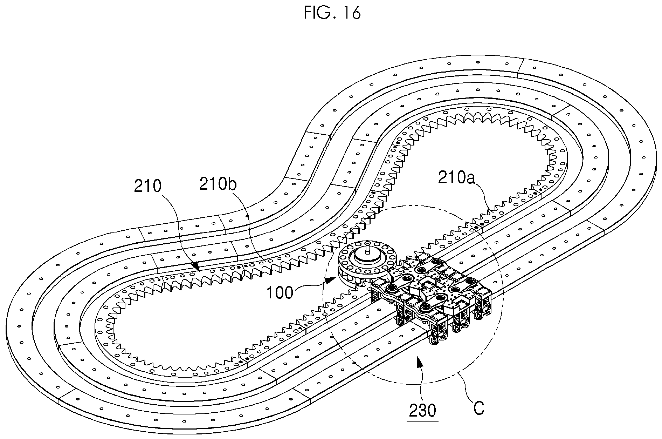

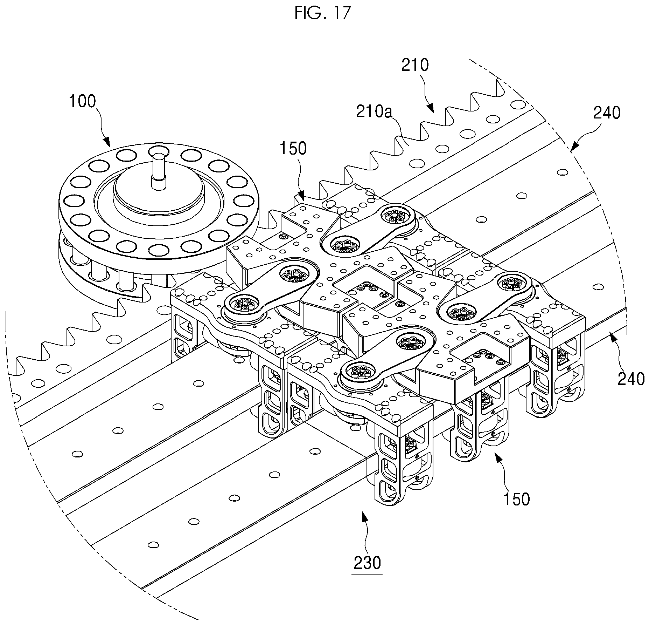

FIG. 16 is a perspective view of a driving device according to another embodiment of the present inventive concept, and FIG. 17 is an enlarged view of a region C of FIG. 16.

In a case of the embodiment described above, as illustrated in FIG. 1, the pair of module rails 140 are arranged on both sides of the rack 110.

In the present embodiment, however, a pair of module rails 240 are disproportionately arranged in one side area of a rack 210. In other words, in the present embodiment, the module rail 240 is adopted in a pair, and the pair of module rails 240 are disproportionately arranged in one side area of the rack 210.

The rack 210 interacting with the pinion 100 are assigned with a different reference numeral because the trajectory thereof is different from that of the embodiment described above.

In FIGS. 16 and 17, the configuration of the moving unit (120, see FIG. 2) is omitted, and the moving unit 120 may move along the trajectory of the rack 210 while forming one body with the pinion 100 and the pair of slipping prevention guide assemblies 150, as in the embodiment described above. The structure, function, and role of the pair of slipping prevention guide assemblies 150 are the same as those of the embodiment described above, and thus, redundant descriptions thereof are omitted. Even when the present embodiment is adopted, the effect of the present inventive concept may be provided.

While this inventive concept has been particularly shown and described with reference to preferred embodiments thereof, it will be understood by those of ordinary skill in the art that various changes in form and details may be made therein without departing from the spirit and scope of the inventive concept as defined by the appended claims. Therefore, the scope of the inventive concept is defined not by the detailed description of the inventive concept but by the appended claims, and all differences within the scope will be construed as being included in the present inventive concept.

### INDUSTRIAL APPLICABILITY

The present inventive concept may be used for industrial machinery, semiconductor or flat display manufacturing equipment, and various logistics transfer equipment, and the like.

## Claims

1. A driving device comprising:
a rack formed in at least any one combination of a straight rack portion of a straight type and a curved rack portion of a curved type;
a pinion interacting with the rack and moving along a straight or curved trajectory of the rack;
a moving unit connected to the pinion and moving along the trajectory of the rack with the pinion; and
a guide module connected to the moving unit and guiding a movement of the moving unit that moves along the trajectory of the rack,
wherein the guide module comprises:
a pair of module rails, each comprising a rail block and arranged on one side of the rack forming a same trajectory as the rack; and
a pair of slipping prevention guide assemblies connected to the moving unit forming one body with the pinion, one of which being movably coupled to each of the pair of module rails, and moving along the trajectory of each of the pair of module rails and guiding the movement of the moving unit to prevent occurrence of slipping.

2. The driving device of claim 1, wherein the pair of slipping prevention guide assemblies have an identical structure, and each of the pair of slipping prevention guide assemblies comprises a plurality of unit guide units, each of the plurality of unit guide units comprising an upper roller, a lower roller, and a side roller which are respectively guided in rolling contact with all of an upper surface, a lower surface, and a side surface of the rail block.

3. The driving device of claim 2, wherein each of the pair of slipping prevention guide assemblies further comprises a unit connection portion that connects the plurality of unit guide units into one body to allow the plurality of unit guide units to perform a relative movement or a relative rotation on the rail block.

4. The driving device of claim 3, wherein the unit connection portion comprises:
a main unit body connected to a pair of unit guide units arranged in a middle among the plurality of unit guide units; and
a plurality of individual unit connectors, each individually connecting each pair of unit guide units arranged on one side and another side among the plurality of unit guide units.

5. The driving device of claim 4, wherein the unit connection portion further comprises:
a pair of center bearings respectively coupled to both sides of the main unit body;
a plurality of side bearings respectively provided at center portions of the individual unit connectors; and
a pair of link arms, both end portions of each of which are respectively coupled to each of the plurality of center bearings and each of the plurality of side bearings to be capable of free rotation.

6. The driving device of claim 2, wherein each of the plurality of unit guide units comprises:
a roller support casing rotatably supporting the upper roller, the lower roller, and the side roller;
an upper flat guide having a flat shape, connected to the upper roller to prevent slipping when the upper roller rolls on an upper surface of the rail block, and connected to an upper coupling hole of the roller support casing with adjustable clearance;
a lower flat guide having a flat shape, connected to the lower roller to prevent slipping when the lower roller rolls on a lower surface of the rail block, and connected to a lower coupling hole of the roller support casing with adjustable clearance; and
a side flat guide having a flat shape, connected to the side roller to prevent slipping when the side roller rolls on a side surface of the rail block, and connected to a side coupling hole of the roller support casing with adjustable clearance.

7. The driving device of claim 6, wherein each of the plurality of unit guide units further comprises:
an upper guide fastening plate fastening the upper flat guide at an opposite side of the upper flat guide with the upper coupling hole therebetween;
a lower guide fastening plate fastening the lower flat guide at an opposite side of the lower flat guide with the lower coupling hole therebetween;
a side guide fastening plate fastening the side flat guide at an opposite side of the side flat guide with the side coupling hole therebetween; and
a plurality of fastening bolts fastening corresponding ones of the upper guide fastening plate and the upper flat guide, the lower guide fastening plate and the lower flat guide, and the side guide fastening plate and the side flat guide.

8. The driving device of claim 6, wherein each of the plurality of unit guide units further comprises:
an upper guide assembly portion assembling the upper roller and the upper flat guide;
a lower guide assembly portion assembling the lower roller and the lower flat guide; and
a side guide assembly portion assembling the side roller and the side flat guide.

9. The driving device of claim 6, wherein each of the plurality of unit guide units further comprises a plurality of preload bolt fastened to the roller support casing and applying a preload for clearance adjustment of the upper roller, the lower roller, and the side roller.

10. The driving device of claim 1, wherein each of the pair of module rails further comprises a detachable block cover covering and protecting the rail block and detachably coupled to the rail cover.

11. The driving device of claim 1, wherein the pair of module rails are arranged on both sides of the rack with the rack therebetween.

12. A guide module arranged in at least any one side of a rack that interacts with a pinion, connected to a moving unit that moves along a trajectory of the rack with the pinion, and guiding a movement of the moving unit, the guide module comprising:
a pair of module rails, each including a rail block and arranged on one side of the rack forming a same trajectory as the rack; and
a pair of slipping prevention guide assemblies connected to the moving unit forming one body with the pinion, one of which being movably coupled to each of the pair of module rails, and moving along the trajectory of the module rail and guiding the movement of the moving unit to prevent occurrence of slipping.

13. The guide module of claim 12, wherein the pair of slipping prevention guide assemblies have an identical structure, and each of the pair of slipping prevention guide assemblies comprises:
a plurality of unit guide units, each of the plurality of unit guide units comprising an upper roller, a lower roller, and a side roller which are respectively guided in rolling contact with all of an upper surface, a lower surface, and a side surface of the rail block; and a unit connection portion that connects the plurality of unit guide units into one body to allow the plurality of unit guide units to perform a relative movement or a relative rotation on the rail block.

14. The guide module of claim 13, wherein the unit connection portion comprises:
a main unit body connected to a pair of unit guide units arranged in a middle among the plurality of unit guide units;
a plurality of individual unit connectors, each individually connecting each pair of unit guide units arranged in one side and another side among the plurality of unit guide units;
a pair of center bearings respectively coupled to both sides of the main unit body;
a plurality of side bearings respectively provided at center portions of the individual unit connectors; and
a pair of link arms, both end portions of each of which are respectively coupled to each of the plurality of center bearings and each of the plurality of side bearings to be capable of free rotation.

15. The guide module of claim 13, wherein each of the plurality of unit guide units comprises:
a roller support casing rotatably supporting the upper roller, the lower roller, and the side roller;
an upper flat guide having a flat shape, connected to the upper roller to prevent slipping when the upper roller rolls on an upper surface of the rail block, and connected to an upper coupling hole of the roller support casing with adjustable clearance;
a lower flat guide having a flat shape, connected to the lower roller to prevent slipping when the lower roller rolls on a lower surface of the rail block, and connected to a lower coupling hole of the roller support casing with adjustable clearance; and
a side flat guide having a flat shape, connected to the side roller to prevent slipping when the side roller rolls on a side surface of the rail block, and connected to a side coupling hole of the roller support casing with adjustable clearance.

16. The guide module of claim 15, wherein each of the plurality of unit guide units further comprises:
an upper guide fastening plate fastening the upper flat guide at an opposite side of the upper flat guide with the upper coupling hole therebetween;
a lower guide fastening plate fastening the lower flat guide at an opposite side of the lower flat guide with the lower coupling hole therebetween;
a side guide fastening plate fastening the side flat guide at an opposite side of the side flat guide with the side coupling hole therebetween; and
a plurality of fastening bolts fastening corresponding ones of the upper guide fastening plate and the upper flat guide, the lower guide fastening plate and the lower flat guide, and the side guide fastening plate and the side flat guide.

17. The guide module of claim 15, wherein each of the plurality of unit guide units further comprises:
an upper guide assembly portion assembling the upper roller and the upper flat guide;
a lower guide assembly portion assembling the lower roller and the lower flat guide; and
a side guide assembly portion assembling the side roller and the side flat guide.

18. The guide module of claim 15, wherein each of the plurality of unit guide units further comprises a plurality of preload bolt fastened to the roller support casing and applying a preload for clearance adjustment of the upper roller, the lower roller, and the side roller.

19. The guide module of claim 12, wherein each of the pair of module rails further comprises a detachable block cover covering and protecting the rail block and detachably coupled to the rail cover.

20. The guide module of claim 12, wherein the pair of module rails are arranged on both sides of the rack with the rack therebetween.
